# EUROPEAN PATENT APPLICATION

(11) **EP 4 397 792 A1**
(43) Date of publication of application: **10.07.2024**
(21) Application number: 23793224.9
(22) Date of filing: 21.08.2023
(51) Int. Cl.: C30B 1/10, C30B 29/22, C01G 53/00, H01M 10/0525, H01M 4/36

(54) **SINGLE CRYSTAL TERNARY POSITIVE ELECTRODE MATERIAL, FABRICATION METHOD THEREFOR, AND LITHIUM-ION BATTERY**

(30) Priority: 24.11.2022 CN 202211484260
(71) Applicant: Tianjin B&M Science And Technology Co., Ltd., Tianjin 300384 (CN)
(72) Inventor: The designation of the inventor has not yet been filed
(74) Representative: Meroni, Francesca
(86) International application number: PCT/CN2023/114100
(87) International publication number: WO 2024/109205

(57) **Abstract**

The present disclosure provides a single-crystal ternary cathode material and a manufacturing method thereof, and a lithium ion battery, including: aiding primary sintering with a first target ion M; performing a pulverizing treatment on a primary sintered product, to obtain a pulverized product; uniformly mixing the pulverized product and a second additive and performing secondary sintering, to obtain a secondary sintered product, i.e., aiding the secondary sintering with a second target ion N; uniformly mixing the secondary sintered product and a coating agent and performing tertiary sintering, to obtain the single-crystal ternary cathode material. In the sintering processes, the first target ion M and the second target ion N have a fluxing property, then a monocrystallized cathode material can be formed at a relatively low temperature, thus reducing the manufacturing cost of the single-crystal ternary cathode material. In the present disclosure, by adding the first target ion M and the second target ion N in the sintering processes, and using the pulverizing treatment, the single-crystal ternary cathode material that has relatively high dispersity, a lower aggregation rate, and a relatively uniform size is formed at a relatively low temperature.

## Description

### Cross-reference to Related Applications

The present disclosure claims priority to the Chinese patent application with the filing No. 202211484260.1 filed with the China National Intellectual Property Administration on November 24, 2022 and entitled "Single-crystal Ternary Cathode Material and Manufacturing Method thereof, and Lithium Ion Battery", the contents of which are incorporated herein by reference in entirety.

### Technical Field

The present disclosure relates to the field of batteries, in particular to a single-crystal ternary cathode material and a manufacturing method thereof, and a lithium ion battery.

### Background Art

With the development of society, increasing demand for energy source and continuous consumption thereof are promoting research on renewable energy sources. Among renewable energy sources, lithium ion batteries are widely used in electric vehicles, electronic devices, energy storage and other fields due to advantages such as high volume/mass energy density, no memory effect, safety, and environmental protection. In the composition of each component of the lithium ion batteries, the cathode material plays a vital role.

In recent years, the ternary cathode material has attracted widespread attention in the industry because of its high discharge specific capacity, high energy density, and low cost. At present, in order to increase the energy density of the cathode material, two methods have been proposed. One is to increase the capacity per gram of the material, corresponding to a high nickelization route, and the other is to increase the voltage of the material, corresponding to a monocrystallization route, i.e., to form a single-crystal ternary cathode material.

However, at present, the single-crystal ternary cathode material currently has the shortcomings such as high synthesis temperature and relatively large size of single-crystal particles, which in turn affect the transmission performance and electrochemical performance of the cathode material in the lithium ion batteries.

### Summary

In view of this, an objective of the present disclosure is to provide a single-crystal ternary cathode material, a manufacturing method thereof, and a lithium ion battery, wherein a single-crystal ternary cathode material having both good transmission performance and good electrochemical performance can be manufactured.

In order to achieve the above objective, the following technical solutions are provided in the present disclosure.

An example of the present disclosure provides a method of manufacturing a single-crystal ternary cathode material, including:
uniformly mixing a ternary precursor, a lithium salt, and a first additive and performing primary sintering on the same, to obtain a primary sintered product, wherein the first additive at least includes a first target ion M;
performing a pulverizing treatment on the primary sintered product, to obtain a pulverized product, wherein particle size distribution parameters of the pulverized product and particle size distribution parameters of the ternary precursor at least partially overlap (i.e., have overlapping parts);
uniformly mixing the pulverized product and a second additive and performing secondary sintering on the same, to obtain a secondary sintered product, wherein the second additive at least includes a second target ion N; and
uniformly mixing the secondary sintered product and a coating agent and performing tertiary sintering on the same, to obtain the single-crystal ternary cathode material, wherein the first target ion M and the second target ion N are used for reducing a formation temperature of the single-crystal ternary cathode material, and particle size distribution parameters of the single-crystal ternary cathode material satisfy target threshold ranges.

Optionally, the step of performing a pulverizing treatment on the primary sintered product, to obtain a pulverized product includes:
performing a first treatment on the primary sintered product, wherein particle size distribution parameters of the primary sintered product having undergone the first treatment and the particle size distribution parameters of the ternary precursor do not overlap; and
performing a second treatment on the primary sintered product having undergone the first treatment, wherein the particle size distribution parameters of the primary sintered product having undergone the second treatment and the particle size distribution parameters of the ternary precursor at least partially overlap.

Optionally, the particle size distribution parameters at least include particle size valuesincluding D₅₀ and D₁₀₀ and span including K₉₀.

The particle size distribution parameters of the ternary precursor are 3 µm≤D₅₀≤6 µm, 5 µm≤D₁₀₀≤9 µm, and 0.5≤K₉₀≤1.0.

The particle size distribution parameters of the pulverized product are 3.0 µm≤D₅₀≤4.5 µm, 7.0 µm≤D₁₀₀≤12.0 µm, and 0.70≤K₉₀≤1.00.

Optionally, the particle size distribution parameters include at least aggregation rate Sₚ, and a target threshold range of a first aggregation rate of the single-crystal ternary cathode material and a threshold range of a second aggregation rate of the pulverized product at least partially overlap.

Optionally, the target threshold ranges of the particle size distribution parameters of the single-crystal ternary cathode material are 3.0 µm≤D₅₀≤5.0 µm, 7.0 µm≤D₁₀₀≤15.0 µm, 0.60≤K₉₀≤1.20, 2.0≤Sₚ≤3.0.

Optionally, the first target ion M is one or more of Mg²⁺, Al³⁺, Zr⁴⁺, Ti⁴⁺, Y³⁺, Sr²⁺, B³⁺, Nb⁵⁺, W⁶⁺, and Mo⁶⁺.

Optionally, the second target ion N is one or more of Co²⁺, Y³⁺, W⁶⁺, Mg²⁺, Al³⁺, Zr⁴⁺, Ti⁴⁺, Nb⁵⁺, Sr²⁺, and B³⁺.

An example of the present disclosure provides a single-crystal ternary cathode material. The single-crystal ternary cathode material includes a matrix and a coating layer, wherein the matrix at least includes a first target ion M and a second target ion N.

The first target ion M and the second target ion N are used to reduce a formation temperature of the single-crystal ternary cathode material; and particle size distribution parameters of the single-crystal ternary cathode material satisfy target threshold ranges.

Optionally, the target threshold ranges of the particle size distribution parameters of the single-crystal ternary cathode material are 3.0 µm≤D₅₀≤5.0 µm, 7.0 µm≤D₁₀₀≤15.0 µm, 0.60≤K₉₀≤1.20, and 2.0≤Sₚ≤3.0.

An example of the present disclosure provides a lithium ion battery. The lithium ion battery at least includes the single-crystal ternary cathode material according to any one of the above examples.

An example of the present disclosure provides a method of manufacturing a single-crystal ternary cathode material, including: uniformly mixing a ternary precursor, a lithium salt, and a first additive and performing primary sintering on the same, to obtain a primary sintered product, wherein the first additive at least includes a first target ion M, i.e., the sintering is aided by the first target ion M; performing a pulverizing treatment on the primary sintered product, to obtain a pulverized product, wherein particle size distribution parameters of the pulverized product and particle size distribution parameters of the ternary precursor at least partially overlap, i.e., by controlling the particle size distribution of the single-crystal ternary cathode material to be subsequently formed through the pulverizing treatment, excessive aggregation of the single-crystal ternary cathode material to be formed is avoided, and dispersity of the single-crystal ternary cathode material is improved; uniformly mixing the pulverized product and a second additive and performing secondary sintering on the same, to obtain a secondary sintered product, wherein the second additive at least includes a second target ion N, i.e., the sintering is aided continuously by the second target ion N; and uniformly mixing the secondary sintered product and a coating agent and performing tertiary sintering on the same, to obtain a single-crystal ternary cathode material, wherein particle size distribution parameters of the single-crystal ternary cathode material satisfy target threshold ranges. In the above, in the sintering process, the first target ion M and the second target ion N can be used for reducing a formation temperature of the single-crystal ternary cathode material, and the monocrystallized cathode material can be formed at a relatively low temperature, thereby reducing manufacturing costs of the single-crystal ternary cathode material. It can thus be seen that in the present disclosure, by adding the first target ion M and the second target ion N during the sintering, and using the pulverizing treatment, the single-crystal ternary cathode material that has relatively high dispersity, a lower aggregation rate, a relatively uniform size, and the particle size distribution parameters satisfying the target threshold ranges is formed at a relatively low temperature.

### Brief Description of Drawings

In order to illustrate technical solutions in examples of the present disclosure or in the prior art more clearly, drawings that need to be used in the description of the examples or the prior art are introduced briefly below. Apparently, the drawings in the following description are only for some examples of the present disclosure, and those ordinarily skilled in the art still could obtain other drawings in light of these drawings, without using any inventive efforts.
FIG. 1 shows a schematic flowchart of a method of manufacturing a single-crystal ternary cathode material provided in an example of the present disclosure; and
FIG. 2 shows a schematic diagram of morphology of a cathode material provided in an example of the present disclosure.

### Detailed Description of Embodiments

In order to make the above objectives, features, and advantages of the present disclosure more apparent and understandable, specific embodiments of the present disclosure are described in detail below in combination the drawings.

In the following description, numerous specific details are set forth in order to provide a thorough understanding of the present disclosure. However, the present disclosure may also be implemented in other modes different from those described herein. Those skilled in the art could make similar extensions without departing from the connotation of the present disclosure. Therefore, the present disclosure is not limited to the specific examples disclosed below.

With the development of society, increasing demand for energy and continuous consumption of energy are promoting research on renewable energy sources. Among renewable energy sources, lithium ion batteries are widely used in electric vehicles, electronic devices, energy storage and other fields due to advantages such as high volume/mass energy density, no memory effect, safety, and environmental protection. In the composition of each component of the lithium ion batteries, the cathode material plays a vital role.

In recent years, the ternary cathode material has attracted widespread attention in the industry because of its high discharge specific capacity, high energy density, and low cost. At present, in order to increase the energy density of the cathode material, two methods have been proposed. One is to increase the capacity per gram of the material, corresponding to a high nickelization route, and the other is to increase the voltage of the material, corresponding to a monocrystallization route, i.e., to form a single-crystal ternary cathode material.

At present, the three-time sintering process has become one of the conventional routes for producing a single-crystal material due to its unique advantages. Primary sintering (first-time sintering) controls morphology of primary particles in a short-time high-temperature pre-sintering manner, aiming at that the particles do not aggregate with each other in a first stage, and are easily fused into single crystals in a second stage. Secondary sintering (second-time sintering) optimizes the morphology, and allows more sufficient entry of residual lithium on surface in the first stage into crystal lattices, so as to reduce the residual lithium on the surface, alleviate side reactions on the surface, reduce gas generation of battery, and improve safety performance of the battery. Tertiary sintering (third-time sintering) after surface coating can further address the residual lithium on the surface of the material. By combining the first stage and the second stage, primary particles which are morphologically uniform, regular, even and independent, less cohesive, and prone to monocrystallization are obtained.

The conventional three-time sintering process mainly includes the following two types.

The primary sintering is at a low temperature, and polycrystalline materials after the sintering have good dispersity. However, since energy received is not enough, at a relatively low temperature in the secondary sintering, it is insufficient to sinter a precursor, a lithium salt, and a dopant into single crystals, and only quasi-single crystals or polycrystals can be produced. When a higher temperature is provided for material monocrystallization, the materials are easier to grow into granular materials that are prone to aggregation and uneven in size.

The primary sintering is at a high temperature, and a single-crystal or quasi-single-crystal cathode material can be directly formed, but aggregation is severe. Even if a crushing and pulverizing process is added, the material cannot be well dispersed. In the secondary sintering, since the temperature in the primary sintering is relatively high, the single-crystal morphology has formed, and lithium source has penetrated relatively uniformly, the temperature does not need to be too high. But the pulverized material has poor dispersity, unfavorable uniformity, and relatively large span K₉₀, and particle size value Dₘₐₓ may be abnormal in some cases.

That is to say, the single-crystal ternary material currently has the shortcomings such as high synthesis temperature and relatively large size of single-crystal particles, which in turn affect transmission performance and electrochemical performance of the cathode material in the lithium ion batteries.

In view of this, an example of the present disclosure provides a method of manufacturing a single-crystal ternary cathode material, including: uniformly mixing a ternary precursor, a lithium salt, and a first additive and performing primary sintering on the same, to obtain a primary sintered product, wherein the first additive at least includes a first target ion M, i.e., the sintering is aided by the first target ion M; performing a pulverizing treatment on the primary sintered product, to obtain a pulverized product, wherein particle size distribution parameters of the pulverized product and particle size distribution parameters of the ternary precursor at least partially overlap, i.e., by controlling the particle size distribution of the single-crystal ternary cathode material to be subsequently formed through the pulverizing treatment, excessive aggregation of the single-crystal ternary cathode material to be formed is avoided, and dispersity of the single-crystal ternary cathode material is improved; uniformly mixing the pulverized product and a second additive and performing secondary sintering on the same, to obtain a secondary sintered product, wherein the second additive at least includes a second target ion N, i.e., the sintering is aided continuously by the second target ion N; and uniformly mixing the secondary sintered product and a coating agent and performing tertiary sintering on the same, to obtain a single-crystal ternary cathode material, wherein particle size distribution parameters of the single-crystal ternary cathode material satisfy target threshold ranges. In the above, in the sintering process, the first target ion M and the second target ion N can be used for reducing a formation temperature of the single-crystal ternary cathode material, and the monocrystallized cathode material can be formed at a relatively low temperature, thereby reducing manufacturing costs of the single-crystal ternary cathode material. It can thus be seen that in the present disclosure, by adding the first target ion M and the second target ion N during the sintering, and using the pulverizing treatment, the single-crystal ternary cathode material that has relatively high dispersity, a lower aggregation rate, and a relatively uniform size, and the particle size distribution parameters satisfying the target threshold ranges is formed at a relatively low temperature.

In order to better understand technical solutions and technical effects of the present disclosure, specific examples will be described in detail below in combination with the drawings.

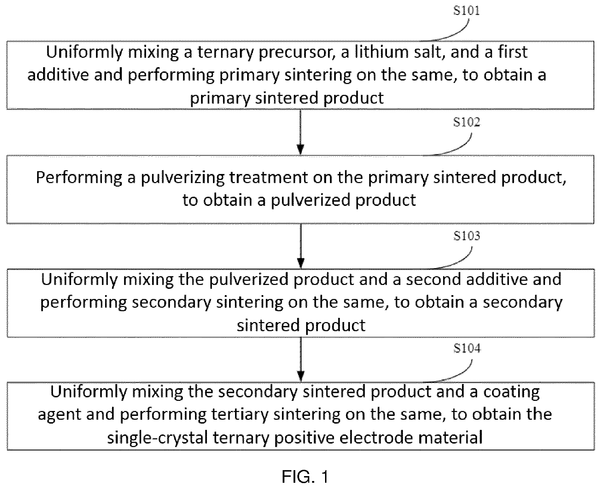

Referring to FIG. 1, it is a flowchart of a method of manufacturing a single-crystal ternary cathode material provided in an example of the present disclosure. The method includes the following steps.

S101, uniformly mixing a ternary precursor, a lithium salt, and a first additive and performing primary sintering on the same, to obtain a primary sintered product.

In an example of the present disclosure, the ternary precursor, the lithium salt, and the first additive can be acquired, wherein the first additive at least includes a first target ion M, and the acquired ternary precursor, lithium salt, and first additive are mixed uniformly and undergo the primary sintering, to obtain the primary sintered product.

In an example of the present disclosure, the first target ion M is introduced with the first additive when the primary sintering is performed. The first target ion M may be an ion having a fluxing property or a lattice strengthening property. The first target ion M forms a low-melting-point fusion-promoting compound with lithium in an oxidation sintering reaction, which reduces thermal stress of crystal formation, and promotes movement of grain boundary, so that crystal growth is more uniform and complete, and single crystals are easier to form. The addition of the first target ion M having the fluxing property enables the formation of monocrystallized primary particles at a relatively low temperature, thereby improving the stability of the single-crystal ternary cathode material.

Specifically, the first target ion M may be one or more of Mg²⁺, Al³⁺, Zr⁴⁺, Ti⁴⁺, Y³⁺, Sr²⁺, B³⁺, Nb⁵⁺, W⁶⁺, and Mo⁶⁺.

In practical applications, a chemical formula of the ternary precursor may be NiₓCo_{y}Mn_{z}(OH)₂, where 0.60≤x≤1.0, 0≤y≤0.30, 0≤z≤0.30, and x+y+z+b=1. The lithium salt is any one or more of lithium hydroxide, lithium carbonate, lithium acetate, and lithium nitrate.

In an example of the present disclosure, the primary sintering is performed under the following conditions: an oxygen atmosphere, a temperature rising rate of 1-5 °C/min (specifically such as 1 °C/min, 1.5 °C/min, 2 °C/min, 2.5 °C/min, 3 °C/min, 3.5 °C/min, 4 °C/min, 4.5 °C/min, 5 °C/min, etc.), a sintering temperature of 300-1000 °C (specifically such as 300 °C, 400 °C, 500 °C, 600 °C, 700 °C, 800 °C, 900 °C, 1000 °C, etc.), and holding time of 2-20 h (specifically such as 2 h, 4 h, 5 h, 8 h, 10 h, 12 h, 14 h, 15 h, 16 h, 18 h, 20 h, etc.). The sintering can be specifically performed in a box furnace.

In an example of the present disclosure, a crystalline state of the ternary precursor can be described by particle size distribution parameters. The particle size distribution parameters at least include particle size values, span, and aggregation rate Sₚ. The particle size values include D₁₀, D₅₀, D₉₀, and D₁₀₀, and the span includes K₉₀. In the above, D₅₀ represents a corresponding particle size value when a cumulative amount in a particle size cumulative distribution curve is 50%, and can be considered as an average particle diameter of a material. Breadth of particle size distribution of a material can be represented by the span K₉₀, K₉₀=(D₉₀-D₁₀)/D₅₀, where the larger K₉₀ is, the wider the particle size distribution of the material is. Aggregation rate Sₚ=D₁₀₀/D₅₀, and the greater the aggregation rate Sₚ is, the greater the aggregation of the material is.

In practical applications, the particle size distribution parameters of the ternary precursor are 3 µm≤D₅₀≤6 µm, 5 µm≤D₁₀₀≤9 µm, 0.5≤K₉₀≤1.0, and 1.5≤Sₚ≤2.0. Specifically, D₅₀ of the ternary precursor may be 3 µm, 3.2 µm, 3.5 µm, 3.8 µm, 4.0 µm, 4.2 µm, 4.5 µm, 4.8 µm, 5.0 µm, 5.2 µm, 5.5 µm, 5.8 µm, 6.0 µm, etc., D₁₀₀ of the ternary precursor may be 5 µm, 5.5 µm, 6 µm, 6.5 µm, 7 µm, 7.5 µm, 8 µm, 8.5 µm, 9 µm, etc., K₉₀ of the ternary precursor may be 0.5, 0.6, 0.7, 0.8, 0.9, 1.0, etc., and Sₚ of the ternary precursor may be 1.5, 1.6, 1.7, 1.8, 1.9, 2.0, etc.

In an example of the present disclosure, by controlling the conditions of the primary sintering, for example, adjusting and improving the sintering temperature, the morphology of the primary sintered product formed after the primary sintering is quasi-single crystal.

S102, performing a pulverizing treatment on the primary sintered product, to obtain a pulverized product.

In an example of the present disclosure, after the primary sintering is performed, the primary sintered product can be subjected to a pulverizing treatment, to obtain a pulverized product. Particle size distribution parameters of the pulverized product and particle size distribution parameters of the ternary precursor at least partially overlap. That is to say, the aggregation of the primary sintered product can be relieved through the pulverizing treatment to the greatest extent, so that the particle size and the span of the pulverized product are as close as possible to those of the ternary precursor, thus a pulverized product having relatively good dispersity is obtained. When performing the pulverizing treatment, pulverization strength can be controlled, then the single-crystal particles can be prevented from forming micro powder due to strong crushing, thereby preventing the micro powder from affecting the electrical property. Meanwhile, the particles are dispersed before being fused into single crystals, thus avoiding problems of difficulty in controlling single crystal cluster growth, non-uniform size of single crystals, large strength required for crushing single crystals and so on that are easily caused by conventional methods.

In an example of the present disclosure, the particle size distribution parameters of the pulverized product are 3.0 µm≤D₅₀≤4.5 µm, 7.0 µm≤D₁₀₀≤12.0 µm, 0.70≤K₉₀≤1.00, and 2.0≤Sₚ≤3.0, which are overlapped a lot with the particle size distribution parameters of the ternary precursor. That is to say, the particle size and the span of the pulverized product having undergone the pulverizing treatment are both relatively close to those of the ternary precursor. The pulverizing treatment can reduce the aggregation and increase the dispersion degree of the single-crystal ternary cathode material. Specifically, D₅₀ of the pulverized product may be 3 µm, 3.2 µm, 3.5 µm, 3.8 µm, 4.0 µm, 4.2 µm, 4.5 µm, etc., D100 of the pulverized product may be 7 µm, 7.5 µm, 8 µm, 8.5 µm, 9 µm, 9.5 µm, 10 µm, 10.5 µm, 11 µm, 11.5 µm, 12 µm, etc., K₉₀ of the pulverized product may be 0.7, 0.75, 0.8, 0.85, 0.9, 0.95, 1.0, etc., and Sₚ of the pulverized product may be 2.1, 2.2, 2.3, 2.4, 2.5, 2.6, 2.7, 2.8, 2.9, 3.0, etc.

In an example of the present disclosure, when the pulverizing treatment is performed on the primary sintered product, two treatments can be performed, that is, the pulverizing treatment includes a first treatment and a second treatment. That is, the aggregation of the primary sintered product is greatly relieved through the two treatments.

In an example of the present disclosure, the first treatment is performed on the primary sintered product. The particle size distribution parameters of the primary sintered product having undergone the first treatment and the particle size distribution parameters of the ternary precursor do not overlap. Then the second treatment is continued on the primary sintered product having undergone the first treatment. The particle size distribution parameters of the primary sintered product having undergone the second treatment and the particle size distribution parameters of the ternary precursor at least partially overlap.

Specifically, a jaw crusher or a rubber hammer can be used for crushing when performing the first treatment. Airflow crushing or mechanical crushing can be used when performing the second treatment. The airflow crushing and the mechanical crushing also can be used to jointly perform the pulverizing treatment.

Specifically, the particle size distribution parameters of the primary sintered product having undergone the first treatment and the particle size distribution parameters of the ternary precursor do not overlap. Specifically, the particle size distribution parameters of the primary sintered product having undergone the first treatment may be 7.00 µm≤D₅₀≤11.00 µm, 60.00 µm≤D₁₀₀≤80.00 µm, 1.30≤K₉₀≤2.00, and 4.0≤Sₚ≤12.0. Specifically, D₅₀ of the primary sintered product having undergone the first treatment may be 7 µm, 7.5 µm, 8 µm, 8.5 µm, 9 µm, 9.5 µm, 10 µm, 10.5 µm, 11 µm, etc., D₁₀₀ of the primary sintered product having undergone the first treatment may be 60 µm, 62 µm, 65 µm, 68 µm, 70 µm, 72 µm, 75 µm, 78 µm, 80 µm, etc., K₉₀ of the primary sintered product having undergone the first treatment may be 1.3, 1.4, 1.5, 1.6, 1.7, 1.8, 1.9, 2.0, etc., and Sₚ of the primary sintered product having undergone the first treatment may be 4, 5, 6, 7, 8, 9, 10, 11, 12, etc.

S103, uniformly mixing the pulverized product and a second additive and performing secondary sintering on the same, to obtain a secondary sintered product.

In an example of the present disclosure, after the pulverized product having relatively high dispersity is obtained, the pulverized product and the second additive can be mixed uniformly and the secondary sintering is performed, to obtain a secondary sintered product, wherein the second additive at least includes the second target ion N.

In an example of the present disclosure, the second target ion N is introduced with the second additive when the secondary sintering is performed. The second target ion N may be an ion having a fluxing property or a lattice strengthening property. The second target ion N forms a low-melting-point fusion-promoting compound with lithium in an oxidation sintering reaction, which reduces thermal stress of crystal formation, and promotes movement of grain boundary, so that crystal growth is more uniform and complete, and single crystals are easier to form. The addition of the second target ion N having the fluxing property enables the formation of the monocrystallized primary particles at a relatively low temperature, thereby improving the stability of the single-crystal ternary cathode material.

Specifically, the second target ion N is one or more of Co²⁺, Y³⁺, W⁶⁺, Mg²⁺, Al³⁺, Zr⁴⁺, Ti⁴⁺, Nb⁵⁺, Sr²⁺, and B³⁺.

In an example of the present disclosure, the secondary sintering is performed under the following conditions: an oxygen atmosphere, a temperature rising rate of 1-5 °C/min (specifically such as 1 °C/min, 1.5 °C/min, 2 °C/min, 2.5 °C/min, 3 °C/min, 3.5 °C/min, 4 °C/min, 4.5 °C/min, 5 °C/min, etc.), a sintering temperature of 800-1200 °C (specifically such as 800 °C, 850 °C, 900 °C, 950 °C, 1000 °C, 1050 °C, 1100 °C, 1150 °C, 1200 °C, etc.), and holding time of 5-15 h (specifically such as 5 h, 8 h, 10 h, 12 h, 14 h, 15 h, etc.). The sintering can be specifically performed in a box furnace.

In an example of the present disclosure, only the second additive is added and no lithium source is added in the second sintering, which can prevent the dispersed single-crystal materials from adhering together due to the fusion-promoting effect of lithium, which is adverse to morphology control. Meanwhile, by choosing the second additive that facilitates dispersion, relatively good dispersity of the particles can be maintained.

In practical applications, after the secondary sintering, an additional crushing treatment or pulverizing treatment also can be performed on the secondary sintered product.

S104, uniformly mixing the secondary sintered product and a coating agent and performing tertiary sintering on the same, to obtain the single-crystal ternary cathode material.

In an example of the present disclosure, after the secondary sintered product is obtained from the secondary sintering, the secondary sintered product and the coating agent can be uniformly mixed and subjected to tertiary sintering, i.e., heat treatment is performed, to obtain the single-crystal ternary cathode material. In this way, having undergone the tertiary sintering with the coating agent, crystal lattice defects can be reduced, the structure on the surface of the material can be stabilized, and the stability of the single-crystal ternary cathode material finally formed can be improved.

In an example of the present disclosure, the particle size distribution parameters of the single-crystal ternary cathode material finally formed meet target threshold ranges. That is to say, the single-crystal ternary cathode material meeting the target threshold ranges can have better electrochemical performance. Specifically, the coating agent is a compound formed by one or more elements of Al, W, Ti, Mg, Zr, B, Ba, V, Mo, Co, F, P, and La.

In an example of the present disclosure, the single-crystal ternary cathode material manufactured through the three times of sintering has a chemical formula of LiₐNiₓCo_{y}Mn_{z}M_{b}N_{c}O₂, where 1.00≤a≤1.15, 0.50≤x≤1.0, 0≤y≤0.30, 0≤z≤0.30, and x+y+z+b=1.

In an example of the present disclosure, the tertiary sintering is performed under the following conditions: an oxygen atmosphere, a temperature rising rate of 0.5-5 °C/min (specifically such as 0.5 °C/min, 1 °C/min, 1.5 °C/min, 2 °C/min, 2.5 °C/min, 3 °C/min, 3.5 °C/min, 4 °C/min, 4.5 °C/min, 5 °C/min, etc.), a sintering temperature of 200-700 °C (specifically such as 200 °C, 250 °C, 300 °C, 350 °C, 400 °C, 450 °C, 500 °C, 550 °C, 600 °C, etc.), and holding time of 2-8 h (specifically such as 2 h, 3 h, 4 h, 5 h, 6 h, 7 h, 8 h, etc.).

In an example of the present disclosure, a target threshold range of a first aggregation rate of the single-crystal ternary cathode material finally obtained and a threshold range of a second aggregation rate of the pulverized product at least partially overlap. That is to say, after the secondary sintering and the tertiary sintering, the dispersity of the material is less affected, and the single-crystal ternary cathode material which is morphologically uniform, and has relatively good dispersity and narrower particle size distribution can be finally formed.

Specifically, the target threshold ranges of the particle size distribution parameters of the single-crystal ternary cathode material may be 3.00 µm≤D₅₀≤5.00 µm, 7.00 µm≤D₁₀₀≤15.00 µm, 0.60≤K₉₀≤1.20, and 2.0≤Sₚ≤3.0. Specifically, D₅₀ of the single-crystal ternary cathode material may be 3 µm, 3.2 µm, 3.5 µm, 3.8 µm, 4 µm, 4.2 µm, 4.5 µm, 4.8 µm, 5 µm, etc., D₁₀₀ of the single-crystal ternary cathode material may be 7 µm, 8 µm, 9 µm, 10 µm, 11 µm, 12 µm, 13 µm, 14 µm, 15 µm, etc., K₉₀ of the single-crystal ternary cathode material may be 0.6, 0.7, 0.8, 0.9, 1.0, 1.1, 1.2, etc., and Sₚ of the single-crystal ternary cathode material may be 2, 2.1, 2.2, 2.3, 2.4, 2.5, 2.6, 2.7, 2.8, 2.9, 3.0, etc.

It can thus be seen that, regarding the current problems of particle aggregation, poor dispersity, and particle uniformity when manufacturing the single-crystal ternary cathode material, in the examples of the present disclosure, by precisely controlling the sintering temperatures in the first sintering stage and the second sintering stage and the selection of doping ions, the particle size and the span of the obtained cathode material are controlled, and the single-crystal ternary cathode material with narrower particle size distribution is prepared. By optimizing the sintering process, doping ions, and coating system, crystal lattice defects can be reduced, and the surface structure of the material can be stabilized, so that the high capacity of the material is ensured, the rate performance as well as cycle stability and safety of the battery are improved, thus improving the battery performance.

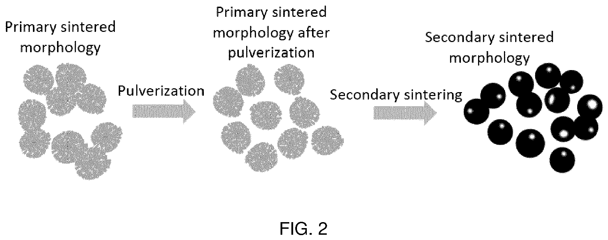

That is to say, referring to FIG. 2, it is a schematic diagram of morphology of the cathode material provided in an example of the present disclosure. It can be seen from FIG. 2 that, by adjusting the primary sintering temperature, primary sintered morphology after the sintering is quasi-single crystal, with slight aggregation. The aggregation can be relieved to a great extent by subsequent crushing treatment and gentle pulverizing treatment, so that the particle size and the span thereof are as close as possible to those of the ternary precursor, and the primary sintered product with relatively good dispersity is obtained. Since the crushing strength is not large, negative effect of affecting the electrical property by micro powder brought about by strong crushing of single crystal particles can be avoided, and meanwhile, the particles are dispersed before being fused into single crystals. Then through the secondary sintering at a relatively low temperature and coating heat treatment, the single-crystal ternary cathode material having uniform morphology, relatively good dispersity, and narrower particle size distribution is obtained.

The method of manufacturing a single-crystal ternary cathode material provided in an example of the present disclosure is specifically described below, with adjustment to the first target ion M and the second target ion N introduced when sintering and the sintering conditions.

A first example is as follows. A ternary precursor with a chemical formula of Ni_{0.8}oCo_{0.10}Mn_{0.10}(OH)₂, where D₅₀=3.96 µm, D₁₀₀= 8.68 µm, and K₉₀=0.84, lithium hydroxide, and MgO were mixed in a ratio of n_{(Ni+co+Mn)}:n_{(Li)}:n_{(Mg)}=1:1.02:0.002, uniformly in a high-speed mixer. Uniform mixture was put into a box furnace and sintered, wherein a temperature rising rate was 3 °C/min, and temperature was raised to 750 °C, and maintained for 6 h. Then sintered product was taken out, cooled, and crushed. Resulting sintered product was smashed into powder by a rubber hammer, until a particle size thereof was measured after sieving to be D₅₀≈7.82 µm, D₁₀₀≈71.83 µm, K₉₀≈1.53, and Sₚ≈9.19. Crushed product was subjected to a further pulverizing treatment using a mechanical crushing device, to obtain a pulverized product, until D₅₀≈3.40 µm, D₁₀₀≈8.42 µm, K₉₀≈0.89, and Sₚ≈2.48. Resulting pulverized product having relatively good uniformity and dispersity was mixed with Co(OH)₂. After uniform mixing, mixture was put into a box furnace and sintered, wherein a temperature rising rate was 1.5 °C/min, and temperature was raised to 950 °C, and maintained for 10 h. Then, sintered product was taken out, cooled, and pulverized. Resulting crushed product was uniformly mixed with BaO, and then tertiary sintering was performed, wherein a temperature rising rate was 5 °C/min, and temperature was raised to 600 °C, and maintained for 2 h. Then sintered product was taken out, cooled, and sieved, and a single-crystal ternary cathode material Li_{1.02}(Ni_{0.80}Co_{0.10}Mn_{0.10})_{0.098}Mg_{0.002}O₂ can be obtained, where D₅₀≈3.51 µm, D₁₀₀≈9.62 µm, K₉₀≈1.14, and Sₚ≈2.74.

A second example is as follows. A ternary precursor with a chemical formula of Ni_{0.90}Co_{0.03}Mn_{0.07}(OH)₂, where D₅₀=3.54 µm, D₁₀₀=7.68 µm, and K₉₀=0.71, was mixed with lithium hydroxide and Al₂O₃ in a ratio of n_{(Ni+Co+Mn)}:n_{(Li)}:n_{(Al)}=1:1.02:0.002, uniformly in a high-speed mixer. Uniform mixture was put into a box furnace and sintered, wherein a temperature rising rate was 3 °C/min, and temperature was raised to 720 °C, and maintained for 5 h. Then sintered product was taken out, cooled, and crushed. Resulting sintered product was taken out, then crushed into small pieces of material by a jaw crusher, and then smashed into powder by a rubber hammer, until a particle size thereof was measured after sieving to be D₅₀≈7.53 µm, D₁₀₀≈68.23 µm, K₉₀≈1.82, and S_{b}≈9.06. Crushed product was subjected to a further pulverizing treatment using a mechanical crushing device, to obtain a pulverized product, until D₅₀≈3.31 µm, D₁₀₀≈8.02 µm, K₉₀≈0.82, and Sₚ≈2.42. Resulting pulverized product having relatively good uniformity and dispersity was mixed with ZrO₂. After uniform mixing, mixture was put into a box furnace and sintered, wherein a temperature rising rate was 2 °C/min, and temperature was raised to 980 °C, and maintained for 10 h. Then, sintered product was taken out, cooled, and pulverized. Resulting crushed product was uniformly mixed with MoOs, and then tertiary sintering was performed, wherein a temperature rising rate was 3 °C/min, and temperature was raised to 200 °C, and maintained for 3 h. Then sintered product was taken out, cooled, and sieved, and a single-crystal ternary cathode material Li_{1.04}(Ni_{0.90}Co_{0.03}Mn_{0.07})_{0.098}Al_{0.002}O₂ can be obtained, where D₅₀≈3.45 µm, D₁₀₀≈8.98 µm, K₉₀≈1.02, and Sₚ≈2.60.

A third example is a modified example of the first example. Different from the first example, the first additive MgO was replaced with Ti(OH)₄, the primary sintering temperature was raised to 700 °C, pulverization particle size after the pulverizing treatment was D₅₀≈3.10 µm, D₁₀₀≈7.59 µm, K₉₀≈0.74, and Sₚ≈2.45, and the secondary sintering temperature was raised to 1030 °C.

A fourth example is a modified example of the first example. Different from the first example, the first additive MgO was replaced with Nb₂O₅, the primary sintering temperature was raised to 840 °C, pulverization particle size after the pulverizing treatment was D₅₀≈3.83 µm, D₁₀₀≈9.02 µm, K₉₀≈0.93, and Sₚ≈2.36, and the secondary sintering temperature was raised to 900 °C.

A fifth example is a modified example of the first example. Different from the first example, the coating agent BaO was changed into WOs, and the tertiary sintering was heated to 600 °C.

A first comparison example is as follows. A ternary precursor, lithium hydroxide, and MgO were mixed in a ratio of n_{(Ni+co+Mn)}:n_{(Li)}:n_{(Mg)}=1:1.02:0.002, uniformly in a high-speed mixer. Uniform mixture was put into a box furnace and sintered, wherein a temperature rising rate was 3 °C/min, and temperature was raised to 350 °C, and maintained for 6 h. Then sintered product was taken out, cooled, and crushed. Resulting sintered product was smashed into powder by a rubber hammer, until a particle size thereof was measured after sieving to be D₅₀≈3.54 µm, D₁₀₀≈8.03 µm, K₉₀≈0.74, and Sₚ≈2.27. Crushed product was subjected to a further pulverizing treatment using a mechanical crushing device, to obtain a pulverized product, until D₅₀≈3.30 µm, D₁₀₀≈6.93 µm, K₉₀≈0.70, and Sₚ≈2.10. Resulting pulverized product having relatively good uniformity and dispersity was mixed with Co(OH)₂. After uniform mixing, mixture was put into a box furnace and sintered, wherein a temperature rising rate was 1.5 °C/min, and temperature was raised to 1100 °C, and maintained for 10 h. Then sintered product was taken out, cooled, and pulverized. Resulting crushed product was uniformly mixed with Al(OH)₃, and then tertiary sintering was performed, wherein a temperature rising rate was 5 °C/min, and temperature was raised to 600 °C, and maintained for 2 h. Then sintered product was taken out, cooled, and sieved, and a single-crystal ternary cathode material Li_{1.02}(Ni_{0.80}Co_{0.10}Mn_{0.10})_{0.098}Mg_{0.002}O₂ can be obtained, where D₅₀≈3.22 µm, D₁₀₀≈6.73 µm, K₉₀≈0.69, and Sₚ≈2.09.

A second comparison example is as follows. A ternary precursor, lithium hydroxide, and MgO were mixed in a ratio of n_{(Ni+co+Mn)}:n_{(Li)}:n_{(Mg)}=1:1.02:0.002, uniformly in a high-speed mixer. Uniform mixture was put into a box furnace and sintered, wherein a temperature rising rate was 3 °C/min, and temperature was raised to 930 °C, and maintained for 6 h. Then sintered product was taken out, cooled, and crushed. Resulting sintered product was smashed into powder by a rubber hammer, until a particle size thereof was measured by sieving to be D₅₀≈8.72 µm, D₁₀₀≈93.85 µm, K₉₀≈1.79, and Sₚ=10.76. Crushed product was subjected to a further pulverizing treatment using a mechanical crushing device, to obtain a pulverized product I, until D₅₀≈5.02 µm, D₁₀₀≈9.64 µm, K₉₀≈0.83, and Sₚ≈1.92. Resulting pulverized product having relatively good uniformity and dispersity was mixed with Co(OH)₂. After uniform mixing, mixture was put into a box furnace and sintered, wherein a temperature rising rate was 1.5 °C/min, and temperature was raised to 900 °C, and maintained for 10 h. Then sintered product was taken out, cooled, and pulverized. Resulting crushed product was uniformly mixed with Al(OH)₃, and then tertiary sintering was performed, wherein a temperature rising rate was 5 °C/min, and temperature was raised to 600 °C, and maintained for 2 h. Then sintered product was cooled, taken out, and sieved, and a single-crystal ternary cathode material Li_{1.02}(Ni_{0.80}Co_{0.10}Mn_{0.10})_{0.098}Mg_{0.002}O₂ can be obtained, where D₅₀≈4.95 µm, D₁₀₀≈9.02 µm, K₉₀≈0.85, and Sₚ≈1.82.

The examples of the present disclosure provide a method of manufacturing a single-crystal ternary cathode material, including: uniformly mixing a ternary precursor, a lithium salt, and a first additive and performing primary sintering on the same, to obtain a primary sintered product, wherein the first additive at least includes a first target ion M, i.e., the sintering is aided by the first target ion M; performing a pulverizing treatment on the primary sintered product, to obtain a pulverized product, wherein particle size distribution parameters of the pulverized product and particle size distribution parameters of the ternary precursor at least partially overlap, i.e., by controlling the particle size distribution of the single-crystal ternary cathode material to be subsequently formed through the pulverizing treatment, excessive aggregation of the single-crystal ternary cathode material to be formed is avoided, and dispersity of the single-crystal ternary cathode material is improved; uniformly mixing the pulverized product and a second additive and performing secondary sintering on the same, to obtain a secondary sintered product, wherein the second additive at least includes a second target ion N, i.e., the sintering is aided continuously by the second target ion N; and uniformly mixing the secondary sintered product and a coating agent and performing tertiary sintering on the same, to obtain a single-crystal ternary cathode material. In the above, in the sintering process, the first target ion M and the second target ion N can be used for reducing a formation temperature of the single-crystal ternary cathode material, and the monocrystallized cathode material can be formed at a relatively low temperature, thereby reducing manufacturing costs of the single-crystal ternary cathode material. It can thus be seen that in the present disclosure, by adding the first target ion M and the second target ion N during the sintering, and using the pulverizing treatment, the single-crystal ternary cathode material that has relatively high dispersity, a lower aggregation rate, and a relatively uniform size is formed at a lower temperature.

Based on the method of manufacturing a single-crystal ternary cathode material provided in the above examples, an example of the present disclosure further provides a single-crystal ternary cathode material. The single-crystal ternary cathode material provided in the example of the present disclosure includes a matrix and a coating layer, wherein the matrix at least includes a first target ion M and a second target ion N, the first target ion M and the second target ion N are used for reducing a formation temperature of the single-crystal ternary cathode material; and particle size distribution parameters of the single-crystal ternary cathode material satisfy target threshold ranges.

Optionally, a chemical formula of the single-crystal ternary cathode material is LiₐNiₓCo_{y}Mn_{z}M_{b}N_{c}O₂, where 1.00≤a≤1.15, 0.50≤x≤1.0, 0≤y≤0.30, 0≤z≤0.30, x+y+z+b=1, M is the first target ion M, N is the second target ion N, and the first target ion M and the second target ion N are used for reducing a formation temperature of the single-crystal ternary cathode material.

In the example of the present disclosure, the target threshold ranges of the particle size distribution parameters of the single-crystal ternary cathode material are 3.0 µm≤D₅₀≤5.0 µm, 7.0 µm≤D₁₀₀≤15.0 µm, 0.60≤K₉₀≤1.20, and 2.0≤Sₚ≤3.0.

Based on the single-crystal ternary cathode materials provided in the foregoing examples, an example of the present disclosure further provides a lithium ion battery. The lithium ion battery provided in the example of the present disclosure includes the single-crystal ternary cathode material provided in the foregoing examples.

In an example of the present disclosure, the single-crystal ternary cathode materials manufactured can be assembled into button batteries (button cells), and subjected to electrochemical performance test.

Specifically, a composite nickel-cobalt-manganese multi-element cathode active substance for a non-aqueous electrolyte secondary battery, acetylene black, and polyvinylidene difluoride (PVDF) were mixed in a mass ratio of 95:3:2, coated on an aluminum foil, dried, and molded by stamping with a pressure of 100 MPa into a cathode sheet having a diameter of 12 mm and a thickness of 120 µm. The cathode sheet then was dried in a vacuum drying oven for 12 h at 120 °C. A Li metal sheet having a diameter of 17 mm and a thickness of 1 mm was used as a negative electrode. A polyethylene porous membrane having a thickness of 25 µm was used as a separator. A mixed solution of LiPF6 of 1 mol/L, ethylene carbonate (EC), and diethyl carbonate (DEC) in equal quantity was used as an electrolytic solution. The cathode sheet, the separator, the negative electrode sheet, and the electrolytic solution were assembled into a button battery in an Ar glove box with both water content and oxygen content of less than 5 ppm.

Seven single-crystal ternary cathode materials manufactured can be assembled into button batteries, and subjected to electrochemical performance test, to test 0.1C discharge specific capacity, initial Coulomb efficiency, and capacity retention rate after 50 cycles respectively. Test results are given in the following table:

| Test Example | 0.1C Discharge Specific Capacity (mAh/g) | Initial Coulomb Efficiency (%) | 50-cycle Capacity Retention Rate (%) |
|---|---|---|---|
| First Example | 208.3 | 95.6 | 94.8 |
| Second Example | 210.2 | 97.0 | 95.6 |
| Third Example | 209.3 | 96.3 | 93.2 |
| Fourth Example | 209.7 | 95.8 | 92.8 |
| Fifth Example | 207.6 | 96.8 | 95.3 |
| First Comparison Example | 201.4 | 93.7 | 92.1 |
| Second Comparison Example | 204.2 | 94.5 | 92.8 |

It can be seen from the above table that, compared with the first comparison example and the second comparison example, the first to fifth examples all have relatively high discharge specific capacity, initial Coulomb efficiency, and cycle retention rate, which is attributed to that the particle size distribution of the single-crystal ternary cathode materials finally formed in the first comparison example and the second comparison example does not meet the requirements of the target threshold ranges.

Various embodiments in the present disclosure are all described in a progressive manner. The same and similar parts between the various examples may be referred to each other, and each example focuses on the differences from other example. Particularly for structure examples, substantially similar to method examples, they are described relatively simply, and reference can be made to the description in parts of the method examples for related parts.

The above-mentioned are merely preferred embodiments of the present disclosure. Although the present disclosure has been disclosed in the above with preferred examples, the present disclosure is not limited thereto. Without departing from the scope of the technical solutions of the present disclosure, any skilled person familiar with the art might make many possible changes or modifications, or equivalent examples with equivalent changes, to the technical solutions in the present disclosure, in accordance with the method and technical contents disclosed in the above. Therefore, without departing from the contents of the technical solutions of the present disclosure, any simple alterations, equivalent changes, and modifications made to the above examples according to the technical essence of the present disclosure are still within the scope of protection of the technical solutions of the present disclosure.

## Claims

1. A method of manufacturing a single-crystal ternary cathode material, comprising:
uniformly mixing a ternary precursor, a lithium salt, and a first additive and performing a primary sintering on a mixture, to obtain a primary sintered product, wherein the first additive at least comprises a first target ion M;
performing a pulverizing treatment on the primary sintered product, to obtain a pulverized product, wherein particle size distribution parameters of the pulverized product and particle size distribution parameters of the ternary precursor at least partially overlap;
uniformly mixing the pulverized product and a second additive and performing a secondary sintering on a mixture, to obtain a secondary sintered product, wherein the second additive at least comprises a second target ion N; and
uniformly mixing the secondary sintered product and a coating agent and performing a tertiary sintering on a mixture, to obtain the single-crystal ternary cathode material, wherein the first target ion M and the second target ion N are used for reducing a formation temperature of the single-crystal ternary cathode material, and particle size distribution parameters of the single-crystal ternary cathode material satisfy a target threshold range.

2. The method according to claim 1, wherein the step of performing a pulverizing treatment on the primary sintered product, to obtain a pulverized product comprises:
performing a first treatment on the primary sintered product, wherein particle size distribution parameters of the primary sintered product having undergone the first treatment and the particle size distribution parameters of the ternary precursor do not overlap; and
performing a second treatment on the primary sintered product having undergone the first treatment, wherein particle size distribution parameters of the primary sintered product having undergone the second treatment and the particle size distribution parameters of the ternary precursor at least partially overlap.

3. The method according to claim 1, wherein the particle size distribution parameters at least comprise particle size values and a span, the particle size values comprise D₅₀ and D₁₀₀, and the span comprises K₉₀;
the particle size distribution parameters of the ternary precursor are 3µm≤D₅₀≤6 µm, 5µm≤D₁₀₀≤9 µm, and 0.5≤K₉₀≤1.0; and
the particle size distribution parameters of the pulverized product are 3.0µm≤D₅₀≤4.5 µm, 7.0µm≤D₁₀₀≤12.0µm, and 0.70≤K₉₀≤1.00.

4. The method according to claim 3, wherein the particle size distribution parameters at least comprise an aggregation rate Sₚ, and a target threshold range of a first aggregation rate of the single-crystal ternary cathode material and a threshold range of a second aggregation rate of the pulverized product at least partially overlap.

5. The method according to claim 4, wherein target threshold ranges of the particle size distribution parameters of the single-crystal ternary cathode material are 3.0µm≤D₅₀≤5.0µm, 7.0µm≤D₁₀₀≤15.0µm, 0.60≤K₉₀≤1.20, and 2.0≤Sₚ≤3.0.

6. The method according to any one of claims 1-5, wherein the first target ion M comprises one or more of Mg²⁺, Al³⁺, Zr⁴⁺, Ti⁴⁺, Y³⁺, Sr²⁺, B³⁺, Nb⁵⁺, W⁶⁺, and Mo⁶⁺.

7. The method according to any one of claims 1-5, wherein the second target ion N comprises one or more of Co²⁺, Y³⁺, W⁶⁺, Mg²⁺, Al³⁺, Zr⁴⁺, Ti⁴⁺, Nb⁵⁺, Sr²⁺, and B³⁺.

8. A single-crystal ternary cathode material, wherein the single-crystal ternary cathode material comprises a matrix and a coating layer, and the matrix at least comprises a first target ion M and a second target ion N; and
the first target ion M and the second target ion N are used to reduce a formation temperature of the single-crystal ternary cathode material; and particle size distribution parameters of the single-crystal ternary cathode material satisfy a target threshold range.

9. The single-crystal ternary cathode material according to claim 8, wherein target threshold ranges of the particle size distribution parameters of the single-crystal ternary cathode material are 3.0µm≤D₅₀≤5.0µm, 7.0µmD₁₀₀≤15.0µm, 0.60≤K₉₀≤1.20, and 2.0≤Sₚ≤3.0.

10. A lithium ion battery, wherein the lithium ion battery at least comprises the single-crystal ternary cathode material according to any one of claim 8 or 9.
